# DEMANDE DE BREVET EUROPEEN

(11) **EP 4 390 557 A1**
(43) Date de publication de la demande: **26.06.2024**
(21) Numéro de dépôt: 22216423.8
(22) Date de dépôt: 23.12.2022
(51) Int. Cl.: G04B 17/04, G04C 3/12, H02N 2/00, H02N 2/10

(54) **RESONATEUR PIEZOELECTRIQUE A SPIRAL, NOTAMMENT POUR MOTEUR ROTATIF D'HORLOGERIE**

(71) Demandeur: The Swatch Group Research and Development Ltd, 2074 Marin (CH)
(72) Inventeur: KAHROBAIYAN, Mohammad Hussein, 2043 Boudevilliers (CH); FERRI, Yvan, 1004 Lausanne (CH); DIDIER, Alexandre, 3235 Erlach (CH); PARATTE, Lionel, 2074 Marin-Epagnier (CH); BORN, Jean-Jacques, 1110 Morges (CH)
(74) Mandataire: ICB SA

(57) **Abrégé**

L'invention concerne un résonateur piézoélectrique (1), notamment pour moteur piézoélectrique rotatif, le résonateur (1) comprenant une embase (3) immobile et une masse oscillante (2) s'étendant autour d'un axe longitudinal, la masse oscillante (2) étant munie d'au moins une masselotte (4), de préférence deux masselottes (4) opposées, caractérisé en ce qu'il comprend un guidage à lames flexibles reliant la masse oscillante (2) à l'embase (3), de manière à pouvoir faire osciller la masse oscillante (2) autour d'un centre de rotation dans un mouvement de balancier, le guidage flexible comprenant au moins une première lame flexible (6) reliée à l'embase (3) et/ou à la masse oscillante (2) pour permettre le déplacement de la masse oscillante (2) par rapport à l'embase (3), le guidage à lames flexibles comprenant un ressort spiral (5) relié à l'embase (3) et/ou à la masse oscillante, le ressort spiral comportant au moins en partie un matériau piézoélectrique actionnable électriquement pour déformer le ressort spiral (5) et faire osciller la masse oscillante (2).

## Description

### Domaine technique de l'invention

L'invention se rapporte au domaine technique des résonateurs piézoélectriques, notamment pour moteur piézoélectrique rotatif. L'invention se rapporte également au domaine technique des pièces d'horlogeries munies d'un tel moteur piézoélectrique rotatif.

### Arrière-plan technologique

Les moteurs électriques usuellement utilisés en horlogerie sont des moteurs rotatifs de type « Lavet », qui fonctionnent sur des principes physiques électromagnétiques. Un tel moteur comporte généralement un stator muni de bobines et un rotor aimanté, qui tourne par actionnement déphasé des bobines.

Cependant, ces moteurs ont une résistance limitée aux champs magnétiques élevés. A partir d'une certaine valeur de champs magnétique, le moteur se bloque. En général, ils se bloquent sous l'effet d'un champ magnétique qui dépasse 2 mT.

Ainsi, pour éviter ce problème, il est nécessaire de concevoir des moteurs fonctionnant sur d'autres principes physique.

Il existe par exemple des moteurs électrostatiques à peignes, tel que celui décrit dans le brevet CH709512. Mais les peignes prennent de la place, et ils consomment une énergie plus élevée que les moteurs de type « Lavet ».

Des moteurs basés sur l'effet piézoélectrique ont aussi été mis au point, par exemple dans le brevet EP0587031. Mais celui-ci est limité à l'actionnement d'un quantième. En outre, sa consommation élevée et le risque d'usure prématurée ne permettent pas l'entraînement d'une aiguille des secondes, qui demande en général le plus d'énergie.

### Résumé de l'invention

Le but de la présente invention est de proposer un résonateur piézoélectrique, notamment pour moteur piézoélectrique rotatif, qui peut résister à des champs électromagnétiques élevés, tout en gardant une consommation d'énergie et un volume réduits.

A cet effet, l'invention se rapporte à un résonateur piézoélectrique, notamment pour moteur piézoélectrique rotatif d'une pièce d'horlogerie, le résonateur comprenant une embase immobile et une masse oscillante s'étendant autour d'un axe longitudinal, la masse oscillante étant munie d'au moins une masselotte, de préférence deux masselottes opposées.

L'invention est remarquable en ce que qu'il comprend un guidage à lames flexibles reliant la masse oscillante à l'embase, de manière à pouvoir faire osciller la masse oscillante autour d'un centre de rotation dans un mouvement de balancier, le guidage flexible comprenant au moins une première lame flexible reliée à l'embase et/ou à la masse oscillante pour permettre le déplacement de la masse oscillante par rapport à l'embase, le guidage à lames flexibles comprenant un ressort spiral relié à l'embase et/ou à la masse oscillante, le ressort spiral comportant au moins en partie un matériau piézoélectrique actionnable électriquement pour déformer le ressort spiral et faire osciller la masse oscillante.

Un résonateur ayant une telle configuration permet de fournir un mouvement avec efficacité. En effet, en actionnant le matériau piézoélectrique du ressort-spiral, ce dernier se contracte et s'étire alternativement, de sorte que la masse oscillante oscille en pivotant sur elle-même autour d'un centre de rotation, grâce à la lame ou aux lames flexibles du guidage flexible. Ainsi, le résonateur produit un mouvement oscillatoire de la masse oscillante, tout en consommant peu d'énergie, car l'actionnement de la ou des lames flexibles demande moins d'énergie.

Le mouvement oscillatoire peut ainsi être transmis à d'autres pièces mécaniques selon le domaine d'application du résonateur piézoélectrique, par exemple à une roue dentée d'un moteur.

Selon une forme de réalisation particulière de l'invention, le guidage flexible comporte une deuxième lame flexible reliant la masse oscillante à l'embase, la première lame flexible reliant l'embase à la masse oscillante.

Selon une forme de réalisation particulière de l'invention, la première lame flexible et la deuxième lame flexible sont décroisées et s'écartent depuis une partie centrale de la masse oscillante jusqu'à des parties excentrées de l'embase.

Selon une forme de réalisation particulière de l'invention, la première lame flexible et la deuxième lame flexible sont agencées pour former un angle compris entre 30° et 150°, de préférence entre 60° et 130°, voire entre 90° et 120°.

Selon une forme de réalisation particulière de l'invention, le ressort spiral est relié à la masse oscillante pour actionner l'oscillation.

Selon une forme de réalisation particulière de l'invention, le guidage flexible comprend deux pivots flexibles de type RCC, le guidage flexible étant muni d'un élément mobile intermédiaire, une première paire de lame flexibles munie de la première lame flexible et d'une deuxième lame flexible, la première paire de lame flexibles reliant l'embase à l'élément mobile intermédiaire, et une deuxième paire de lames flexibles, reliant l'élément mobile intermédiaire à la masse oscillante.

Selon une forme de réalisation particulière de l'invention, la première lame flexible et la deuxième lame flexible sont décroisées et s'écartent depuis l'élément mobile intermédiaire jusqu'à des parties excentrées de l'embase.

Selon une forme de réalisation particulière de l'invention, la première lame flexible et la deuxième lame flexible sont agencées pour former un angle compris entre 30° et 100°, de préférence entre 40° et 80°.

Selon une forme de réalisation particulière de l'invention, la première lame flexible et la deuxième lame flexible sont agencées par symétrie axiale l'une par rapport à l'autre.

Selon une forme de réalisation particulière de l'invention, le ressort spiral est relié à l'élément intermédiaire et à l'embase, le ressort spiral produisant l'oscillation de l'élément intermédiaire lorsqu'il est actionné.

Selon une forme de réalisation particulière de l'invention, le ressort-spiral est agencé entre la première paire de lames flexibles et la deuxième paire de lames flexibles.

Selon une forme de réalisation particulière de l'invention, le ressort-spiral et la première paire de lames flexibles sont agencés pour former un angle compris entre 60° et 120°, de préférence entre 80° et 100°.

Selon une forme de réalisation particulière de l'invention, le ressort-spiral et la deuxième paire de lames flexibles sont agencés pour former un angle compris entre 20° et 60°, de préférence entre 30° et 45°.

Selon une forme de réalisation particulière de l'invention, le guidage flexible comprend deux pivots flexibles de type RCC, le guidage flexible étant muni d'un élément mobile intermédiaire, une paire de lame flexibles munie de la première lame flexible, la paire de lame flexibles reliant l'élément mobile intermédiaire à la masse oscillante, le ressort-spiral reliant l'embase à l'élément mobile intermédiaire, le guidage flexible comprenant un deuxième ressort-spiral reliant l'embase à l'élément mobile intermédiaire, le deuxième ressort-spiral comportant un matériau piézoélectrique actionnable électriquement pour déformer le deuxième ressort spiral et faire osciller la masse oscillante.

Selon une forme de réalisation particulière de l'invention, le premier ressort-spiral et le deuxième ressort-spiral sont agencés pour former un angle compris entre 80° et 160°, de préférence entre 100° et 140°, voire entre 110° et 130°.

Selon une forme de réalisation particulière de l'invention, le premier ressort-spiral et le deuxième ressort-spiral sont agencés par symétrie axiale l'un par rapport à l'autre.

Selon une forme de réalisation particulière de l'invention, le résonateur piézoélectrique est agencé sensiblement dans un même plan.

Selon une forme de réalisation particulière de l'invention, le résonateur est configuré pour faire osciller la masse oscillante à la fréquence propre du résonateur.

Selon une forme de réalisation particulière de l'invention, le résonateur comporte, de préférence majoritairement, un matériau monocristallin ou poly-cristallin amagnétique et de basse conductivité, tels que le silicium, le verre, la céramique, ou un métal, et obtenu par exemple par un procédé photo-lithographique de micro-usinage de type MEMS.

Selon une forme de réalisation particulière de l'invention, le guidage flexible est monobloc.

L'invention se rapporte également à un moteur piézoélectrique, notamment pour un dispositif d'affichage d'une pièce d'horlogerie, comprenant un tel résonateur piézoélectrique.

Selon une forme de réalisation particulière de l'invention, le moteur piézoélectrique comprend au moins un cliquet, de préférence deux cliquets, et une roue mobile, le cliquet étant monté sur la masse oscillante du résonateur piézoélectrique, de manière à faire tourner la roue mobile dans un premier sens, lorsque la masse oscillante effectue ses oscillations.

L'invention se rapporte encore à une pièce d'horlogerie comportant un mouvement d'horlogerie comprenant une transmission d'engrenages configurée pour faire tourner au moins une aiguille, et comprenant un tel moteur piézoélectrique agencé pour actionner la transmission d'engrenages.

### Brève description des figures

D'autres particularités et avantages ressortiront clairement de la description qui en est faite ci-après, à titre indicatif et nullement limitatif, en référence aux dessins annexés, dans lesquels :
- la figure 1 représente schématiquement une vue en perspective de dessus d'un premier mode de réalisation d'un résonateur piézoélectrique, notamment pour un moteur rotatif, selon l'invention,
- la figure 2 représente schématiquement une vue en perspective de dessus d'un deuxième mode de réalisation d'un résonateur piézoélectrique, notamment pour un moteur rotatif, selon l'invention,
- la figure 3 représente schématiquement une vue de dessus d'un troisième mode de réalisation d'un résonateur piézoélectrique, notamment pour moteur rotatif, selon l'invention, et
- la figure 4 représente schématiquement une vue en perspective de dessus d'un moteur piézoélectrique rotatif comprenant un tel résonateur.

### Description détaillée de l'invention

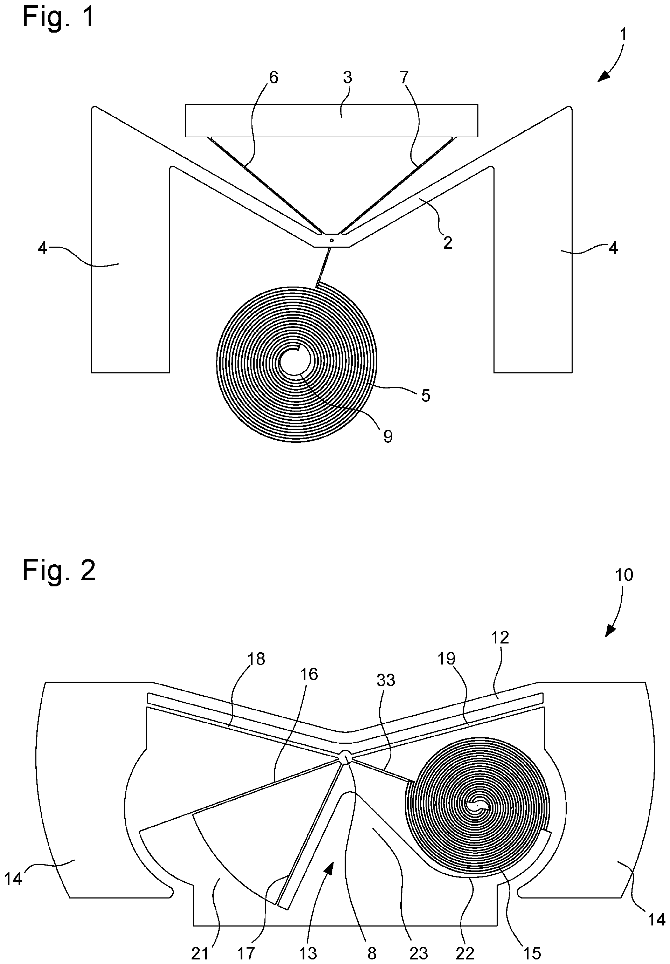

Les figures 1 à 3 montrent des modes de réalisation différents d'un résonateur piézoélectrique 1, 10, 20, notamment utilisé dans un moteur rotatif. Le moteur peut notamment servir dans une pièce d'horlogerie pour actionner un dispositif d'affichage comprenant des aiguilles agencées pour se déplacer sur un cadran. Le résonateur piézoélectrique 1, 10, 20 s'étend de préférence sensiblement dans un plan.

Sur la figure 1, le premier mode de réalisation de résonateur piézoélectrique 1 comprend une embase 3, qui a ici une forme sensiblement rectangulaire.

Le résonateur piézoélectrique 1 comprend en outre une masse oscillante 2, ici en forme de M. La masse oscillante 2 comprend un bras principal en forme de V, aux extrémités duquel sont agencées deux masselottes 4, ici sensiblement droites, et s'étendant à l'opposé de l'embase 13.

L'embase 3 est agencée au-dessus du M. La masse oscillante 2 et l'embase 3 sont agencées de préférence dans un même plan.

Le résonateur comprend un guidage à lames flexibles reliant la masse oscillante 2 à l'embase 3, de manière à pouvoir faire osciller la masse oscillante 2 autour d'un centre de rotation dans un mouvement de balancier. Le centre de rotation est agencé sensiblement au milieu de la masse oscillante 2, c'est-à-dire au milieu du bras, de préférence au centre de masse de la masse oscillante 2.

Le guidage flexible comprend deux lames flexibles. Une première lame flexible 6 et une deuxième lame flexible 7 sont reliées à une même partie centrale de la masse oscillante 2, ici au sommet intérieur du M, et forment un pivot de type RCC (Remote Center of Compliance).

La première lame flexible 6 et la deuxième lame flexible 7 sont en outre reliées à deux parties opposés excentrées de l'embase 3, ici au niveau des coins du rectangle.

La première lame flexible 6 et la deuxième lame flexible 7 sont décroisées et s'écartent depuis l'intérieur la masse oscillante 2 jusqu'à l'embase 3.

La première lame flexible 6 et la deuxième lame flexible 7 sont agencées pour former un angle non nul entre elles, l'angle étant compris entre 30° et 150°, de préférence entre 60° et 130°, voire entre 90° et 120°.

Selon l'invention, le guidage à lames flexibles comprend en outre un ressort spiral 5 relié à la masse oscillante 2. Le ressort spiral 5 est agencé de l'autre côté du M par rapport à l'embase 3.

Le ressort spiral 5 comprend plusieurs spires élastiques. Le ressort spiral 5 comprend une extrémité interne reliée à un plot fixe 18, et extrémité externe se prolongeant par un segment sensiblement rectiligne relié au mobile intermédiaire 8.

Le ressort spiral 5 comporte au moins en partie un matériau piézoélectrique actionnable électriquement pour le déformer et faire osciller la masse oscillante 2. Le matériau piézoélectrique est, de préférence agencée sur toute la longueur du ressort spiral 5. Le ressort spiral 5 comprend par exemple une couche de matériau piézoélectrique prise en sandwich entre deux couches d'électrodes.

Les couches d'électrodes sont elles-mêmes agencées au-dessus d'un matériau structurel de support monobloc, par exemple du silicium monocristallin ou polycristallin, tel que du quartz, du verre, du métal, etc...

Pour actionner la lame enroulée, le plot immobile 9 comprend des contacts électriques reliés aux couches d'électrodes pour recevoir une tension électrique et actionner les couches piézoélectriques du ressort spiral 5.

Les couches piézoélectriques comportent de préférence un matériau cristallin ou polycristallin, par exemple en céramique solide (pour niobate de Potassium sodium) ou de type PZT (pour titano-zirconates de plomb.

L'activation est produite avec une tension alternative. Ainsi, en activant électriquement les couches de matériau piézoélectrique, le ressort spiral 5 se contracte et s'étire alternativement en un mouvement de rotation autour de son centre, afin de produire un déplacement rotatif de la masse oscillante 2 via l'élément intermédiaire 8. L'oscillation est produite à une certaine fréquence, de préférence à la fréquence de résonance du résonateur 1.

Les couches piézoélectriques disposées sur toute la surface du ressort-spiral 5 augmentent considérablement l'efficacité de l'actionneur, par rapport à une simple lame flexible et droite occupant le même espace.

La masse oscillante 2 est guidée dans son mouvement par les deux lames flexibles 6, 7 du guidage flexible formant un pivot de type RCC, de manière à effectuer un mouvement de balancier autour d'un centre de rotation. Ainsi, la masse oscillante 2 oscille et les deux masselottes 4 se déplacent latéralement à une certaine fréquence, de préférence la fréquence propre du résonateur 1. La masse oscillante 2 effectue des oscillations autour du centre de rotation situé au centre de l'élément mobile intermédiaire 8.

Dans le deuxième mode réalisation de la figure 2, le résonateur piézoélectrique 10 comprend une embase 13, qui a ici deux parties incurvée 21, 22 agencées de part et d'autre d'une partie centrale 23 sensiblement triangulaire, et s'étendant vers la masse oscillante 12.

Le résonateur 10 comprend en outre une masse oscillante 12. La masse oscillante 12 comprend un bras principal aux extrémités duquel sont agencées deux masselottes 14, s'étendant de part et d'autre de l'embase 13. Le bras est disposé tangentiellement au sommet du triangle. Le bras est sensiblement courbe au milieu pour ménager une place, par exemple pour un rotor d'un moteur. La masse oscillante 12 et l'embase 13 sont agencées de préférence dans un même plan.

Le résonateur comprend un guidage à lames flexibles reliant la masse oscillante 12 à l'embase 13, de manière à pouvoir faire osciller la masse oscillante 12 autour d'un centre de rotation dans un mouvement de balancier.

Le guidage flexible comprend un premier pivot de type RCC. Un tel pivot comprend un élément mobile intermédiaire 8, une première paire de lame flexibles 16, 17 reliant l'embase à l'élément mobile intermédiaire 8, et une deuxième paire de lame flexibles reliant l'élément mobile intermédiaire à la masse oscillante 12, et formant un deuxième pivot de type RCC.

L'élément mobile intermédiaire 8 est un élément ponctuel, de petite taille par rapport à l'embase 13 et à la masse oscillante 12. L'élément ponctuel 8 a par exemple une forme cylindrique. De préférence, le centre de rotation est agencé sensiblement au centre de l'élément mobile intermédiaire 8.

La première paire de lames flexibles comprend une première lame flexible 16 et une deuxième lame flexible 17 reliant l'embase 13 à l'élément mobile intermédiaire 8. De préférence, la première lame flexible 16 et la deuxième lame flexible 17 sont sensiblement droites.

La première lame flexible 16 et la deuxième lame flexible 17 sont décroisées et s'écartent depuis l'élément mobile intermédiaire 8 jusqu'à une même première partie incurvée 21 de l'embase 13.

La première lame flexible 16 et la deuxième lame flexible 17 sont agencées pour former un angle entre 30° et 100°, de préférence entre 40° et 80°.

La deuxième paire de lames flexibles comporte une troisième lame flexible 18, et une quatrième lames flexible 19 s'étendant depuis l'élément mobile intermédiaire 8 jusqu'à la masse oscillante 12, plus particulièrement en haut des masselottes 14, en-dessous du bras. La deuxième paire de lames flexibles forme un deuxième pivot de type RCC.

Ainsi, les lames flexibles 16, 17, de la première paire de lames flexibles s'étendent d'un côté opposé aux lames flexibles 18, 19 de la deuxième paire.

La troisième lame flexible 18, et la quatrième lames flexible 19 sont agencées pour former un angle compris entre 30° et 150°, de préférence entre 60° et 130°, voire entre 90° et 120°.

Selon l'invention, le guidage flexible comporte en outre un ressort-spiral 15 comportant un matériau piézoélectrique, qui est sensiblement identique au ressort-spiral 5 du premier mode de réalisation de la figure 1.

Le ressort spiral 15 est agencé entre l'embase 13 et l'élément mobile intermédiaire 8, en particulier dans la deuxième partie incurvée 22 de l'embase 13. Le ressort spiral 15 est en outre relié à chacun d'eux par un segment droit 33 relié à l'élément mobile intermédiaire 8 et à l'extrémité interne étant reliée à l'embase 13.

Le ressort-spiral 15 et la première paire de lames flexibles 16, 17, en particulier la deuxième lame flexible 17, sont agencés pour former un angle compris entre 60° et 120°, de préférence entre 80° et 100°. Le ressort-spiral 5 et la deuxième paire de lames flexibles 18, 19, en particulier la quatrième lame flexible 19, sont agencés pour former un angle compris entre 20° et 60°, de préférence entre 30° et 45°.

Dans ce mode de réalisation, lorsque le ressort spiral 15 est actionné, il agit sur l'élément mobile intermédiaire 8, de manière à le faire osciller. Le mouvement de l'élément mobile intermédiaire 8 est guidé par la première paire de lames flexibles 16, 17.

L'oscillation de l'élément mobile intermédiaire 8 est transmise à la masse oscillante 12, grâce à la deuxième paire de lames flexibles 18, 19.

Ainsi, la masse oscillante 12 oscille autour d'un centre de rotation agencé ici au centre de l'élément intermédiaire 8. Les deux masselottes 14 se déplacent latéralement à une certaine fréquence, de préférence la fréquence propre du résonateur 10.

Un double pivot de type RCC permet d'augmenter l'amplitude d'oscillation de la masse oscillante 12, grâce à la deuxième paire de lames flexibles 18, 19.

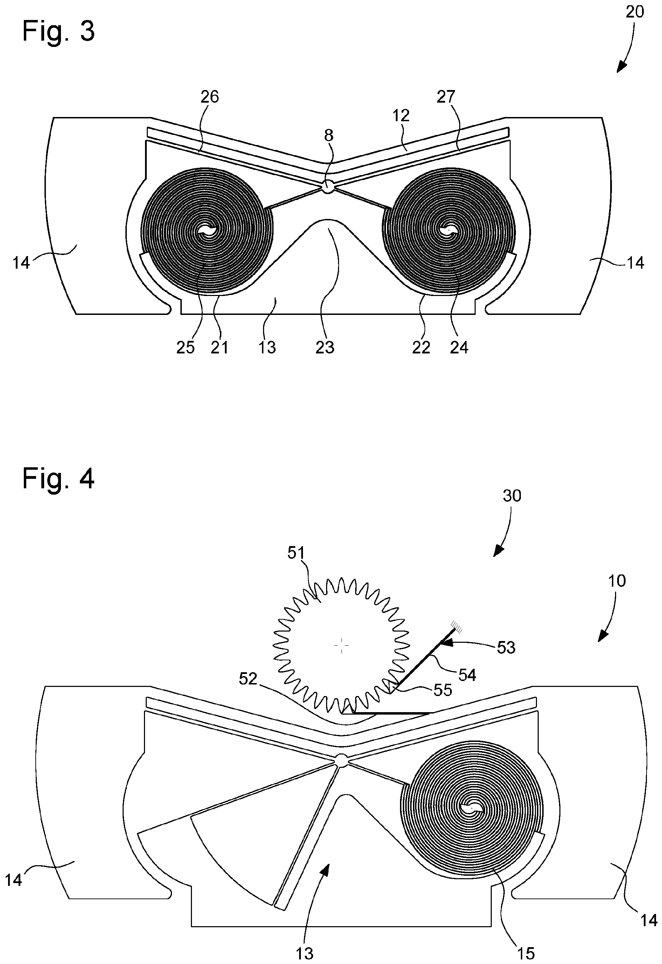

Le troisième mode de réalisation d'un résonateur piézoélectrique 20 de la figure 3, comprend une embase 13, qui a ici deux parties incurvée 21, 22 agencées de part et d'autre d'une partie centrale 23 sensiblement triangulaire, et s'étendant vers la masse oscillante 12.

La masse oscillante 12 du résonateur piézoélectrique 20 comprend un bras principal aux extrémités duquel sont agencées deux masselottes 14, s'étendant de part et d'autre de l'embase 13. Le bras est disposé tangentiellement au sommet du triangle. Le bras est sensiblement courbe au milieu pour se rapprocher du sommet principal du triangle. La masse oscillante 12 et l'embase 13 sont agencées de préférence dans un même plan.

Le résonateur piézoélectrique 20 comprend un guidage à lames flexibles 16, 17 reliant la masse oscillante 12 à l'embase 13, de manière à pouvoir faire osciller la masse oscillante 12 autour d'un centre de rotation dans un mouvement de balancier.

Le guidage flexible comprend deux pivots de type RCC (. Un tel guidage flexible comprend généralement un élément mobile intermédiaire 8, une première paire de lame flexibles 26, 27 reliant l'élément mobile intermédiaire 8 à la masse oscillante 12, et une deuxième paire de lame flexibles reliant l'embase 13 à l'élément mobile intermédiaire 8.

Dans ce mode de réalisation, la deuxième paire de lames flexibles du deuxième pivot de type RCC sont remplacées par des ressorts-spiraux.

L'élément mobile intermédiaire 8 est un élément ponctuel, de petite taille par rapport à l'embase 3 et à la masse oscillante 2. L'élément ponctuel 8 a par exemple une forme cylindrique. De préférence, le centre de rotation est agencé au centre de l'élément mobile intermédiaire 8.

La première paire de lames flexibles comprend une première lame flexible 26 reliant l'élément mobile intermédiaire à l'embase 13, et une deuxième lame flexible 27 reliant l'embase 13 à l'élément mobile intermédiaire 8.

Le guidage flexible comprend un premier ressort-spiral 5 et un deuxième ressort-spiral 25. Chaque ressort spiral 5, 25 est agencé entre l'embase 3 et l'élément mobile intermédiaire 8, en particulier dans chaque partie incurvée 21, 22 de l'embase 3.

L'élément mobile intermédiaire 8 est en outre relié à chacun d'eux par un segment droit, les extrémités internes de chaque ressort-spiral étant reliées à l'embase 3. Ainsi, le premier ressort-spiral 5 et le deuxième ressort-spiral 25 s'étendent d'un côté opposé aux lames flexibles 26, 27 de la première paire.

Le premier ressort-spiral 24 et le deuxième ressort-spiral 25 sont agencés pour former un angle compris entre 80° et 160°, de préférence entre 100° et 140°, voire entre 110° et 130°. Le premier ressort-spiral 24 et le deuxième ressort-spiral 25 sont agencés par symétrie axiale l'un par rapport à l'autre.

Le premier ressort-spiral 24 et le deuxième ressort-spiral 25 sont sensiblement identiques aux ressorts-spiraux du premier et du deuxième mode de réalisation. Les deux ressort-spiraux 24, 25 comportent également un matériau piézoélectrique.

Dans ce mode de réalisation, les deux ressorts-spiraux 5, 25 sont actionnés, de préférence alternativement. Ainsi, ils agissent sur l'élément mobile intermédiaire 8, de manière à le faire osciller. Le mouvement rotatif de l'élément mobile intermédiaire 8 est ainsi guidé par les ressorts-spiraux 24, 25, comme le ferait un pivot de type RCC à lames droites.

L'oscillation de l'élément mobile intermédiaire 8 est transmis la masse oscillante 12, grâce à la deuxième paire de lames flexibles 26, 27.

Ainsi, la masse oscillante 2 oscille autour d'un centre de rotation correspondant au point de croisement des deux lames flexibles des paires, ici au niveau de l'élément intermédiaire 8. Les deux masselottes 14 se déplacent latéralement à une certaine fréquence.

Un pivot de type RCC permet d'augmenter l'amplitude d'oscillation de la masse oscillante 2, grâce à la deuxième paire de lames flexibles 9, 11.

Les résonateurs 1, 10, 20 selon les modes de réalisation décrits précédemment, comportent, de préférence majoritairement, un matériau mono- cristallin ou poly-cristallin, tels que le silicium, le verre, la céramique, ou un métal.

Les résonateurs 1, 10, 20 sont par exemple obtenus par des procédés photo-lithographiques de micro-usinage de type MEMS (pour micro-electro mechanical systems), Les qualités de rigidité, d'élasticité et la précision d'usinage de tels matériaux confèrent une grande performance de résonance aux résonateurs 1, 10, 20.

De plus, les caractéristiques d'amagnétisme et de basse conductivité de certains de ces matériaux permettent d'obtenir une excellente résistance aux champs magnétiques continus et alternatifs de valeurs élevées.

En outre, les résonateurs 1, 10, 20 sont configurés pour faire osciller la masse oscillante 2, 12 à la fréquence propre du résonateur 1, 10, 20. Ainsi, on limite la consommation d'énergie du résonateur, notamment en augmentant la course angulaire de la masse oscillante.

La figure 4 montre un mode de réalisation d'un moteur piézoélectrique 30 rotatif, notamment pour un dispositif d'affichage d'une pièce d'horlogerie. Le moteur piézoélectrique 30 peut notamment servir dans une pièce d'horlogerie pour actionner un dispositif d'affichage, comme des aiguilles agencées sur un cadran. Le moteur piézoélectrique 30 est configuré pour pouvoir tourner et actionner une transmission d'engrenages mécanique du dispositif d'affichage.

Le moteur piézoélectrique 30 comprend un résonateur piézoélectrique selon l'invention, ici le résonateur piézoélectrique 10 du deuxième mode de réalisation de la figure 2. Les autres modes de réalisation de résonateur piézoélectrique peuvent également être utilisés sans que cela change le fonctionnement du moteur piézoélectrique 10. Le résonateur piézoélectrique 10 est par exemple assemblé à une platine par son embase 13.

Le moteur piézoélectrique 10 comprend en outre une roue mobile 51 dentée et deux cliquets 52, 53 configurés pour faire tourner la roue mobile 51 dans un seul sens. La roue mobile 51 comprend de préférence une denture périphérique, de préférence asymétrique, qui définit le sens de rotation. La roue mobile 51 est reliée à un rouage muni d'aiguilles du dispositif d'affichage.

Le premier cliquet 52 a pour fonction de faire tourner la roue mobile 51 dans un premier sens, par exemple antihoraire, tandis que le deuxième cliquet 53 retient la roue mobile 51 lorsque le premier cliquet 52 se réarme sur la dent suivante du rotor 51.

Chaque cliquet 52, 53 comporte une lame flexible 54 munie d'une dent 55, de préférence asymétrique, à son extrémité.

La rotation de la roue mobile 51 est engendrée grâce au déplacement du premier cliquet 52. Le premier cliquet 52 est monté sur la masse oscillante 12 du résonateur piézoélectrique 10. Ainsi, lorsque le résonateur oscille, le premier cliquet 52 oscille également, de sorte qu'il pousse ou tire la roue mobile 51 dentée dans un premier sens selon le positionnement du résonateur piézoélectrique par rapport à la roue mobile 51.

Le deuxième cliquet 53 est soit assemblé sur la platine un pont de platine, ou directement sur l'embase 30 pour limiter l'erreur de positionnent dû à l'enchaînement des tolérances d'assemblage. Il a pour fonction d'empêcher la roue dentée de tourner dans le sens opposé du premier sens. La dent 55 du deuxième cliquet 53 est configurée pour coopérer avec la denture asymétrique, de manière à laisser la roue mobile 51 tourner dans le premier sens, et à la bloquer dans le sens opposé.

A cette fin, le bras flexible 54 des cliquets 52, 53 sont en position droite relâchée, lorsque la dent 55 est insérée dans la denture de la roue mobile 51, tandis qu'il est armé et courbé lorsqu'il est repoussé par la denture vers l'extérieur, quand la roue mobile 51 tourne dans le premier sens.

Dans le cas d'une montre, la fréquence de résonance ou fréquence propre du moteur 1 est adaptée à la fréquence du quartz, lequel sert à régler la marche du mouvement. On choisit une fréquence d'excitation correspondant à un sous-multiple de la fréquence du quartz, qui est généralement de 32764 Hz. Par exemple, on choisit une fréquence de 128Hz ou 256 Hz. La fréquence du moteur 1 est de préférence ajustée et accordée à la fréquence d'excitation de sorte que son amplitude d'oscillation ne descende pas en-dessous de 90-95% de l'amplitude maximale.

De manière optionnelle, le deuxième cliquet 53 peut être configuré pour servir de capteur de pas, afin de déterminer la distance ou la vitesse de rotation de la roue mobile 51. A cette fin, le bras flexible 54 du deuxième cliquet 53 est doté d'un matériau piézoélectrique relié à une unité de comptage. Ainsi, à chaque courbure du deuxième cliquet 53, l'unité de comptage enregistre une rotation de la roue mobile 51 d'une dent.

On comprendra que diverses modifications et/ou améliorations et/ou combinaisons évidentes pour l'homme du métier peuvent être apportées aux différentes formes d'exécution de l'invention exposée ci-dessus sans sortir du cadre de l'invention définie par les revendications annexées.

## Revendications

1. Résonateur piézoélectrique (1, 10, 20), notamment pour moteur piézoélectrique rotatif, le résonateur (1, 10, 20) comprenant une embase (3, 13) immobile et une masse oscillante (2, 12) s'étendant autour d'un axe longitudinal, la masse oscillante (2, 12) étant munie d'au moins une masselotte (4, 14), de préférence deux masselottes (4, 14) opposées, **caractérisé en ce qu'**il comprend un guidage à lames flexibles reliant la masse oscillante (2, 12) à l'embase (3, 13), de manière à pouvoir faire osciller la masse oscillante (2, 12) autour d'un centre de rotation dans un mouvement de balancier, le guidage flexible comprenant au moins une première lame flexible (6, 16, 26) reliée à l'embase (3, 13) et/ou à la masse oscillante (2, 12) pour permettre le déplacement de la masse oscillante (2, 12) par rapport à l'embase (3, 13), le guidage à lames flexibles comprenant un ressort spiral (5, 15, 24) relié à l'embase (13, 23) et/ou à la masse oscillante (2), le ressort spiral (5, 15, 24) comportant au moins en partie un matériau piézoélectrique actionnable électriquement pour déformer le ressort spiral (5, 15, 24) et faire osciller la masse oscillante (2, 12).

2. Résonateur piézoélectrique selon la revendication 1, dans lequel le guidage flexible comporte une deuxième lame flexible (7) reliant la masse oscillante (2) à l'embase (3), la première lame flexible (6) reliant l'embase (3) à la masse oscillante (2).

3. Résonateur piézoélectrique selon la revendication 2, dans lequel la première lame flexible (6, 16) et la deuxième lame flexible (7) sont décroisées et s'écartent depuis une partie centrale de la masse oscillante (2) jusqu'à des parties excentrées de l'embase (3).

4. Résonateur piézoélectrique selon la revendication 2 ou 3, dans lequel la première lame flexible (6) et la deuxième lame flexible (7) sont agencées pour former un angle compris entre 30° et 150°, de préférence entre 60° et 130°, voire entre 90° et 120°.

5. Résonateur piézoélectrique selon la revendication 3 ou 4, dans lequel la première lame flexible (6) et la deuxième lame flexible (7) sont agencées par symétrie axiale l'une par rapport à l'autre.

6. Résonateur piézoélectrique selon l'une, quelconque, des revendications 2 à 5, dans lequel le ressort spiral (5) est relié à la masse oscillante (2) pour actionner l'oscillation.

7. Résonateur piézoélectrique selon la revendication 1, dans lequel le guidage flexible comprend un deux pivots flexibles de type RCC, le guidage flexible étant muni d'un élément mobile intermédiaire (8), une première paire de lame flexibles (16, 17) munie de la première lame flexible (16) et d'une deuxième lame flexible (17), la première paire de lame flexibles (16, 17) reliant l'embase (13) à l'élément mobile intermédiaire (8), et une deuxième paire de lames flexibles (18, 19), reliant l'élément mobile intermédiaire (8) à la masse oscillante (12).

8. Résonateur piézoélectrique selon la revendication 7, dans lequel la première lame flexible (6) et la deuxième lame flexible (7) sont décroisées et s'écartent depuis l'élément mobile intermédiaire (8) jusqu'à des parties excentrées de l'embase (13).

9. Résonateur piézoélectrique selon la revendication 8, dans lequel la première lame flexible (16) et la deuxième lame flexible (17) sont agencées pour former un angle compris entre 30° et 100°, de préférence entre 40° et 80°.

10. Résonateur piézoélectrique selon la revendication 6, dans lequel la première lame flexible (16) et la deuxième lame flexible (17) sont agencées par symétrie axiale l'une par rapport à l'autre.

11. Résonateur piézoélectrique selon l'une, quelconque, des revendications 7 à 10, dans lequel le ressort spiral (5) est relié à l'élément intermédiaire (8) et à l'embase (13), le ressort spiral (5) produisant l'oscillation de l'élément intermédiaire (8) lorsqu'il est actionné.

12. Résonateur piézoélectrique selon la revendication 11, dans lequel le ressort-spiral (5) est agencé entre la première paire de lames flexibles (16, 17) et la deuxième paire de lames flexibles (18, 19).

13. Résonateur piézoélectrique selon la revendication 12, dans lequel le ressort-spiral (5) et la première paire de lames flexibles (16, 17) sont agencés pour former un angle compris entre 60° et 120°, de préférence entre 80° et 100°.

14. Résonateur piézoélectrique selon la revendication 12 ou 13, dans lequel le ressort-spiral (5) et la deuxième paire de lames flexibles (16, 17) sont agencés pour former un angle compris entre 20° et 60°, de préférence entre 30° et 45°.

15. Résonateur piézoélectrique selon la revendication 1, dans lequel le guidage flexible comprend deux pivots flexibles de type RCC, le guidage flexible étant muni d'un élément mobile intermédiaire (8), une paire de lame flexibles (26, 27) munie de la première lame flexible (26), la paire de lame flexibles (26, 27) reliant l'élément mobile intermédiaire (8) à la masse oscillante (12), le ressort-spiral (24) reliant l'embase (23) à l'élément mobile intermédiaire (8), le guidage flexible comprenant un deuxième ressort-spiral (25) reliant l'embase (23) à l'élément mobile intermédiaire (8), le deuxième ressort-spiral (25) comportant un matériau piézoélectrique actionnable électriquement pour déformer le deuxième ressort spiral (25) et faire osciller la masse oscillante (12).

16. Résonateur piézoélectrique selon la revendication 15, dans lequel le premier ressort-spiral (5) et le deuxième ressort-spiral (25) sont agencés pour former un angle compris entre 80° et 160°, de préférence entre 100° et 140°, voire entre 110° et 130°.

17. Résonateur piézoélectrique selon la revendication 15 ou 16, dans lequel le premier ressort-spiral (5) et le deuxième ressort-spiral (25) sont agencés par symétrie axiale l'un par rapport à l'autre.

18. Résonateur piézoélectrique selon l'une, quelconque, des revendications précédentes, **caractérisé en ce qu'**il est agencé sensiblement dans un même plan.

19. Résonateur piézoélectrique selon l'une, quelconque, des revendications précédentes, **caractérisé en ce qu'**il est configuré pour faire osciller la masse oscillante (2, 12) à la fréquence propre du résonateur (1, 10, 20).

20. Résonateur selon l'une, quelconque, des revendications précédentes, comportant, de préférence majoritairement, un matériau mono- cristallin ou poly-cristallin amagnétique et de basse conductivité, tels que le silicium, le verre, la céramique, ou un métal, et obtenu par exemple par un procédé photo-lithographique de micro-usinage de type MEMS.

21. Moteur piézoélectrique, notamment pour un dispositif d'affichage d'une pièce d'horlogerie, le moteur piézoélectrique comprenant un résonateur piézoélectrique (1, 10, 20) selon l'une, quelconque, des revendications précédentes.

22. Moteur piézoélectrique selon la revendication 21, comprenant au moins un cliquet (52), de préférence deux cliquets (52, 53), et une roue mobile (51), le cliquet (52) étant monté sur la masse oscillante (32) du résonateur piézoélectrique (1), de manière à faire tourner la roue mobile (51) dans un premier sens, lorsque la masse oscillante (32) effectue ses oscillations.

23. Pièce d'horlogerie comportant un mouvement d'horlogerie comprenant une transmission d'engrenages configurée pour faire tourner au moins une aiguille, **caractérisé en ce qu'**elle comprend un résonateur piézoélectrique (1, 10, 20) ou un moteur piézoélectrique (30) selon l'une, quelconque, des revendications précédentes, le moteur piézoélectrique (30) étant agencé pour actionner la transmission d'engrenages.
